# EUROPEAN PATENT APPLICATION

(11) **EP 3 258 277 A1**
(43) Date of publication of application: **20.12.2017**
(21) Application number: 16174096.4
(22) Date of filing: 13.06.2016
(51) Int. Cl.: G01R 31/02, B66B 1/32

(54) **BRAKE CONTROLLER CIRCUIT OF A PASSENGER CONVEYOR**

(71) Applicant: Kone Corporation, 00330 Helsinki (FI)
(72) Inventor: NIKANDER, Juhamatti, 00330 Helsinki (FI); RAASSINA, Pasi, 00330 Helsinki (FI); HYTTI, Pekka, 00330 Helsinki (FI)
(74) Representative: Glück Kritzenberger Patentanwälte PartGmbB

(57) **Abstract**

The invention relates to a brake controller circuit (10) of a passenger conveyor brake comprising an earth fault detection function, the brake controller circuit comprising:
- a rectifier (12) forming a DC circuit (16) with a positive branch (18) and a negative branch (20), which two branches (18, 20) of the DC circuit (16) are connected to a brake coil (26) of the conveyor brake,
- at least one semiconductor control switch (22, 24) in the positive and negative branch (18, 20) of the DC circuit (16), respectively,
- a positive relay (28) in the positive branch (18) of the DC circuit (16) having a first and second relay contact (32, 34), whereby the first contact (32) is connected with the part of the positive branch (18) connected with the rectifier (12),
- a negative relay (30) in the negative branch (20) of the DC circuit (16) having a first and second relay contact (36, 38), whereby the first contact (36) is connected with the part of the negative branch (20) connected with the rectifier (12),
- a first measuring circuit (40) is connected between the first contact (32) of the positive relay (28) and the second contact (38) of the negative relay (30) and/or a second measuring circuit (48) is connected between the first contact (36) of the negative relay (30) and the second contact (34) of the positive relay (28),
- whereby each measuring circuit (40, 48) is configured to generate a signal corresponding to a current flow between the corresponding contacts (32,38; 36,34) of the relays,
- an output (A, B, C, D) of the measuring circuit(s) (40, 48) is connected with a controller or a safety circuit (62) of the passenger conveyor.

## Description

The subject-matter of the present invention is a brake controller circuit of a passenger conveyor comprising a rectifier forming a DC circuit with a positive branch and a negative branch, which two branches of the DC circuit are connected to a brake coil of the conveyor brake. At least one semiconductor control switch is arranged in the positive as well as in the negative branch of the DC circuit, whereby to each of which semiconductor control switches a diode is connected anti-parallel. The European safety norm EN81-20 requires an earth fault in a circuit controlling the brake whereby in the case of an earth fault detection, the passenger conveyor has to be stopped immediately and a restart of the conveyor has to be stopped too.

It is therefore object of the present invention to provide a brake controller circuit of a passenger conveyor which allows a detection of an earth fault in a conveyor brake. Particularly, it is further object of the invention to detect an earth fault in the brake coil of the conveyor without starting the conveyor, without activating any semiconductor control switches and without burning brake controller fuses.

The object of the invention is solved with a brake controller circuit according to claim 1. The object is furthermore solved with a method for detecting an earth fault in a brake coil of a passenger conveyor according to claim 12. Advantageous embodiments of the invention are subject-matter of the corresponding dependent claims. Advantageous embodiments of the invention are also described in the specification as well as in the drawings.

According to the invention, the brake controller circuit comprises an earth fault detection function which is realized by a positive relay in the positive branch of the DC circuit having first and second relay contacts, whereby the first contact is connected with the part of the positive branch of the DC circuit which is connected with the rectifier. The negative relay is arranged in the negative branch of the DC circuit, also having first and second relay contacts, whereby the first contact is connected with the part of the negative branch which is connected with the rectifier. The inventive brake controller circuit further comprises a first measuring circuit which is connected between the first contact of the positive relay and the second contact of the negative relay and/or a second measuring circuit which is connected between the first contact of the negative relay and the second contact of the positive relay, whereby advantageously both of these relays are provided together.

Each measuring circuit is configured to generate a signal corresponding to a current flow between the corresponding contacts of the negative and positive relay and an output of the measuring circuit is connected with a controller or a safety circuit of the passenger conveyor. The both measuring circuits are provided so that earth fault currents flowing in opposite directions can be detected.

Via opening of the two relays, any current based on an earth fault of the brake coil flows via the measuring circuit/measuring circuits and leads to an output signal of the measuring circuit(s) which is forwarded to the controller or safety circuit of the passenger conveyor to enable immediate stop of the passenger conveyor and disable a restart of the passenger conveyor as required by safety regulations. The advantage of this inventive brake controller circuit is the fact that the earth fault detection can be performed while the passenger conveyor is currently not running. The term passenger conveyor refers to any kind of elevator, escalator, moving ramp or moving sidewalk, generally: any conveyor where passengers are transported with driven conveyor device over a distance.

The measuring circuit can be any circuit which allows the outputting of a signal corresponding to the current flowing between the connected first and second contacts of the positive and negative relay, in a cross connection. In one preferred embodiment, this measuring circuit comprises at least one resistor whereby the voltage drop over the resistor is taken as an output signal of the measuring circuit. This is a very easy arrangement to obtain an earth fault detection signal of the brake coil.

Thus, the voltage of the relay contacts or the current flowing between the relay contacts contacted by the measuring circuit is monitored whereby in case there is a ground/earth fault in the brake coil, a very small ground fault current has a path to flow through the aforementioned measuring circuit and through the antiparallel diode of the semiconductor control switch in the connected branch of the DC circuit. Accordingly, a brake coil earth fault is detected without actually energizing the brakes. No brake supply fuses are blown and the earth fault detection works even if an electric supply system does not have grounded neutral.

In a preferred embodiment of the invention, each of the measuring circuits comprises a voltage divider circuit with two resistors, whereby the voltage over one of the resistors of the voltage divider is measured. In each voltage divider circuit an opto-coupler is connected in series, whereby each of the opto-couplers output are connected to the conveyor control /and or to a safety circuit of the conveyor. The opto-coupler can be used to provide a galvanic separation between the brake controller circuit and the controller or safety circuit of the passenger conveyor.

Advantageously, within each voltage divider circuit, one diode is connected in series. The diodes have the function that current flow over the connected contacts of the positive and negative relay is prohibited in case when the resistors would be in short-circuit and the relay contacts would be open. Therefore, the series-connected diode improves the safety of the measuring circuit.

In a simplified measuring circuit unit, both measuring circuits are mutually connected at a contact point between both resistors of each voltage divider circuit. Thus, the both measuring circuits can be embodied as one combined measuring unit cross-connecting the relays in both directions.

In a preferred embodiment of the invention, the input of at least one opto-coupler is connected to at least one of the measuring circuits and the output of the opto-coupler is connected to the conveyor control or safety circuit of the conveyor. By this means, the brake controller circuit as well as the control or safety circuit of the conveyor are galvanic ally separated.

In a preferred embodiment of the invention, between the two branches of the DC circuit, a diode is connected so that inductive peaks of the brake coil can be cut off. On this behalf, alternatively or additionally a varistor and/or a capacitor can be connected between the positive and negative branch of the DC circuit parallel to the brake coil.

The invention also relates to a method for detecting an earth fault in a brake coil of a passenger conveyor using a brake controller circuit of the above-mentioned type. For detecting the earth fault, both relays are opened and a current is measured with the first measuring circuit from the first contact of the positive relay to the second contact of the negative relay and/or with a second measuring circuit from the first contact of the negative relay to the second contact of the positive relay, which current or voltage signal provided by the measuring circuit(s) is/are fed to a control or safety circuit of the passenger conveyor. With respect to the advantages of this inventive method, it is referred to the advantages of the brake controller circuit as mentioned above. Preferably, the current signal of the measuring circuit is fed to the control or safety circuit of the passenger conveyor via an opto-coupler which enables a galvanic separation of the different electronic circuits.

The semiconductor control switches are per se known in the art and may be e.g. IGBTs or MOS-FETs.

Of course, the functions of the two measuring circuits can be combined in one common measuring unit, which measures the current flowing in both directions.

It shall be emphasized that the above mentioned embodiments can be combined with each other arbitrarily.

Following expressions are used as a synonym: first branch - positive branch; second branch - negative branch;

The invention is hereinafter described with reference to the schematic drawing. In the drawing:
- Fig. 1: shows an electronic diagram of an inventive brake controller circuit comprising earth fault detection of the brake coil using IGBT transistors as semiconductor switches,
- Fig. 2: shows an electronic diagram according to Fig. 1 using MOSFETs as semiconductor switches, and
- Fig. 3: an opto-coupler connection between the measuring circuits and a control or safety relay of the passenger conveyor.

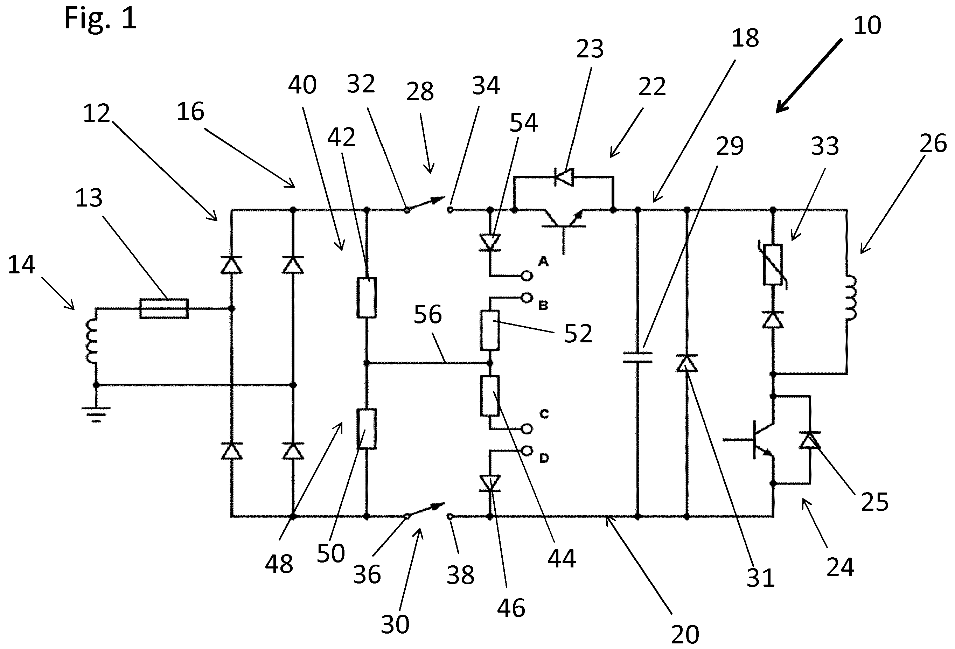

Fig. 1 shows a brake controller circuit 10 having a rectifier bridge 12 connected with an AC power supply network 14, for example a public network, preferably via a fuse 13. A DC circuit 16 is connected to the DC side of the rectifier bridge 12 which DC circuit 16 has a positive branch 18 as well as a negative branch 20. In the positive branch 18, a first semiconductor control switch 22 is located having a first diode 23 connected antiparallel. In the negative branch 20, a second semiconductor control switch 24 is located having a second diode 25 connected antiparallel. The control gate of both semiconductor control switches 22, 24 is controlled by a passenger conveyor control (not shown) to activate or deactivate the brake coil 26 of an operating brake of the conveyor. Between the positive branch 18 and the negative branch 20 of the DC circuit 16, a smoothing diode 29 and a smoothing capacitor 31 are located to smoothen inductive pulses when the brake coil 26 is activated or deactivated. Optionally, a varistor circuit 33 comprising a series connection of a varistor and a diode is connected parallel to the brake coil 26 to cut induced overvoltage pulses of the brake coil 26.

In the positive branch a first relay 28 is connected between the rectifier bridge 12 and the brake coil 26 whereas in the negative branch 20, a negative relay 30 is connected between the rectifier bridge 12 and the brake coil 26. The positive relay 28 has a first contact 32 and a second contact 34.

In the same way, the negative relay has a first contact 36 and a second contact 38. The first contacts 32, 36 of both relays 28, 30 are connected with the rectifier 12.

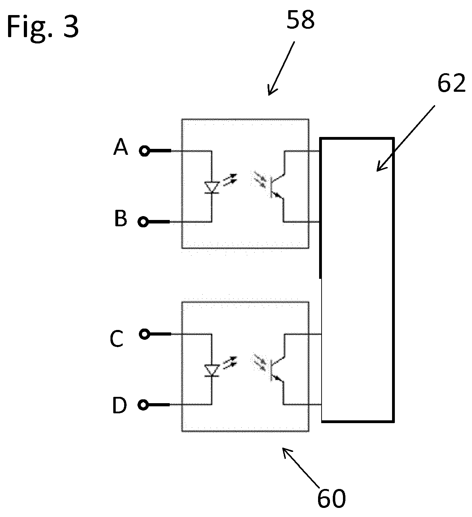

A first measuring circuit 40 is connected between the positive contact 32 of the positive relay 28 and the second contact 38 of the negative relay 30. The first measuring circuit 40 consists of a first resistor 42 and a second resistor 44 connected in series as well as a diode 46 connected in series with the series connection of the first and second resistor 42, 44. In series with the second resistor 44, contacts C, D for the connection of a second opto-coupler 60 (Fig. 3) are provided.

A second measuring circuit 48 is located between the first contact 32 of the negative relay 30 and the second contact 34 of the positive relay 28. The second measuring circuit 48 comprises a third resistor 50 connected in series with a fourth resistor 52 and a diode 54. In series with the fourth resistor 52 contacts A, B are located which are connected to a first opto-coupler 58 to output a signal of the measuring circuit for earth fault detection.

For detecting an earth fault, both relays 28, 30 are opened and any current flowing either via the first measuring circuit 40 or the second measuring circuit 48 is outputted as a voltage signal over the corresponding opto-couplers 58, 60 connected in series with the fourth and second resistors 52, 44. The signal over the output contacts A, B, C, D are fed to the conveyor control or safety circuit. This earth fault check can be performed without the passenger conveyor running or without activating the conveyor brake by energizing the brake coil 26. The first and second measuring circuits 40, 48 are mutually connected via a contact bridge 56 in the middle between the resistors 42, 44 and 50, 52 of the voltage divider circuits of each measuring circuit 40, 48. The voltage divider circuit of each measuring circuit 40, 48 has the effect that the voltage signal via the contacts A, B, C, D is adapted for the series connection with an opto-coupler 58, 60 as shown in Fig. 3.

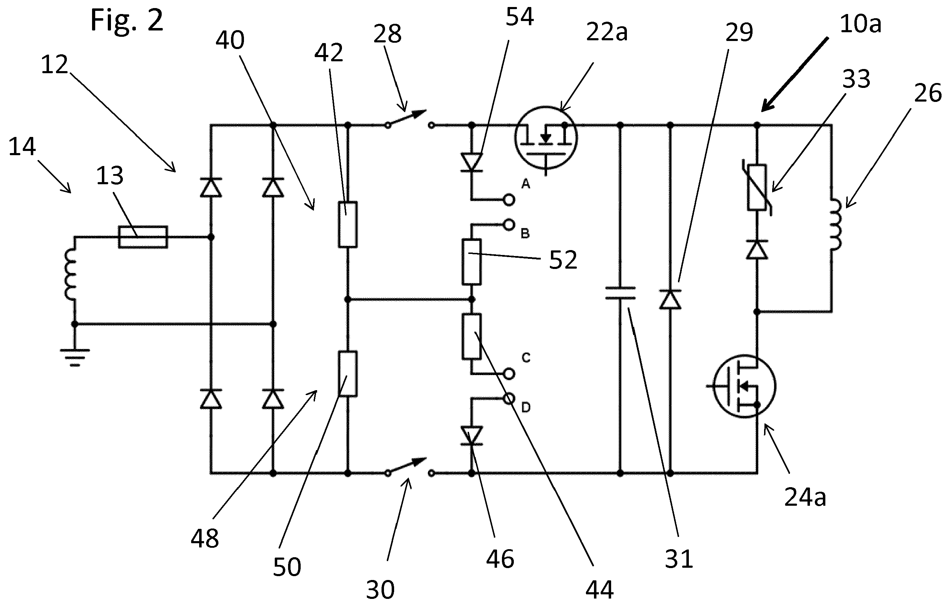

The brake controller 10a of Fig. 2 is nearly identical to the brake controller 10 of Fig. 1 except the fact that the semiconductor switches are here realized as MOSFETs 22a, 24a in contrast to IGBTs 22, 24 which are preferably used in Fig. 1. As the MOSFETs comprise a diode in their internal structure no anti-parallel diodes 23, 25 are needed in this embodiment.

As shown in Fig. 3 the output signals over the contacts A, B and C, D of both measuring circuits 40, 48 of both embodiments of Figs. 1 and 2 are fed to two opto-couplers 58, 60 which are both connected to the safety chain or controller 60 of the passenger conveyor which passenger conveyor might be an elevator, an escalator or a moving sidewalk or a moving ramp. Via the two signals an earth fault current in both directions can be detected, whereby the direction of the earth fault is communicated to the conveyor control.

The invention is not limited to the described embodiment but may be varied within the scope of the appended patent claims.

### Reference number list

- 10: brake controller circuit
- 12: rectifier bridge
- 13: fuse
- 14: public AC network - mains
- 16: DC circuit
- 18: positive branch of the DC circuit
- 20: negative branch of the DC circuit
- 22: first semiconductor control switch (e.g. IGBT)
- 22a: first semiconductor control switch (MOSFET)
- 23: diode of the first semiconductor switch
- 24: second semiconductor control switch (e.g. IGBT)
- 24a: second semiconductor control switch (MOSFET)
- 25: diode of the second semiconductor switch
- 26: brake coil
- 28: positive relay
- 29: smoothing diode
- 30: negative relay
- 31: smoothing capacitor
- 32: first contact of positive relay
- 33: varistor circuit for overvoltage protection
- 34: second contact of positive relay
- 36: first contact of negative relay
- 38: second contact of negative relay
- 40: first measuring circuit
- 42: first resistor
- 44: second resistor
- 46: diode of first measuring circuit
- 48: second measuring circuit
- 50: third resistor
- 52: fourth resistor
- 54: diode of the second measuring circuit
- 56: contact bridge between first and second measuring circuit
- 58: first opto-coupler
- 60: second opto-coupler
- 62: conveyor control and/or safety circuit

## Claims

1. Brake controller circuit (10) of a passenger conveyor brake comprising an earth fault detection function, the brake controller circuit comprising:
- a rectifier (12) forming a DC circuit (16) with a positive branch (18) and a negative branch (20), which two branches (18, 20) of the DC circuit (16) are connected to a brake coil (26) of the conveyor brake,
- at least one semiconductor control switch (22, 24; 22a, 24b) in the positive and negative branch (18, 20) of the DC circuit (16), respectively,
- a positive relay (28) in the positive branch (18) of the DC circuit (16) having a first and second relay contact (32, 34), whereby the first contact (32) is connected with the part of the positive branch (18) connected with the rectifier (12),
- a negative relay (30) in the negative branch (20) of the DC circuit (16) having a first and second relay contact (36, 38), whereby the first contact (36) is connected with the part of the negative branch (20) connected with the rectifier (12),
- a first measuring circuit (40) is connected between the first contact (32) of the positive relay (28) and the second contact (38) of the negative relay (30) and/or a second measuring circuit (48) is connected between the first contact (36) of the negative relay (30) and the second contact (34) of the positive relay (28),
- whereby each measuring circuit (40, 48) is configured to generate a signal corresponding to a current flow between the corresponding contacts (32,38; 36,34) of the relays,
- an output (A, B, C, D) of the measuring circuit(s) (40, 48) is connected with a controller or a safety circuit (62) of the passenger conveyor.

2. Brake controller circuit (10) according to claim 1, wherein the measuring circuit (40, 48) comprises at least one resistor (42, 44; 50,52) whereby a voltage signal over the resistor is provided as output signal of the measuring circuit(s) (40, 48).

3. Brake controller circuit (10) according to claim 2, wherein the measuring circuit (40, 48) comprises a voltage divider circuit with two resistors (42, 44; 50,52), whereby the voltage over one of the resistors (44, 52) of the voltage divider circuit is measured.

4. Brake controller circuit (10) according to claim 3, wherein with each voltage divider circuit (42, 44; 50,52) a diode (46, 54) is connected in series.

5. Brake controller circuit (10) according to claim 3 or 4, wherein both measuring circuits (40, 48) are mutually connected at a contact point (56) between both resistors (42, 44; 50,52) of each voltage divider circuit.

6. Brake controller circuit (10) according to one of the preceding claims, wherein an input (A, B, C, D) of at least one opto-coupler (58, 60) is connected to the corresponding output (A, B, C, D) of at least one of the measuring circuits (40, 48) and the output of the opto-coupler (58, 60) is connected to the conveyor control or safety circuit (62) of the conveyor.

7. Brake controller circuit (10) according to one of the preceding claims, wherein between the two branches (18, 20) of the DC circuit (16) a smoothing diode (29) is connected.

8. Brake controller circuit (10) according to one of the preceding claims, wherein between the two branches (18, 20) of the DC circuit (16) a capacitor (31) is connected.

9. Brake controller circuit (10) according to one of the preceding claims, wherein between the two branches (18, 20) of the DC circuit (16) a capacitor is connected.

10. Brake controller circuit (10) according to one of the preceding claims, wherein parallel to the brake coil (26) a varistor (33) is connected.

11. Brake controller circuit (10) according to one of the preceding claims, wherein to each of the semiconductor control switches (22, 24) a diode (23, 25) is connected anti-parallel,

12. Elevator comprising a brake controller circuit (10) according to one of the preceding claims.

13. Escalator or moving sidewalk comprising a brake controller circuit (10) according to one of claims 1 to 11.

14. Method for detecting an earth fault in a brake coil (26) of a passenger conveyor, using a brake controller circuit (10) with a rectifier (12) feeds a DC circuit (16) with a positive and negative branch (18, 20) to which the brake coil (26) is connected via at least one semiconductor switch (22, 24; 22a, 24a), in which method to the positive and negative branch (18, 20) a corresponding positive/negative relay (28, 30) is connected, whereby the first relay contact of the positive and negative relay (30) is connected with the rectifier (12) and the second contact of the positive and negative relay (28, 30) is connected with the brake coil (26) or semiconductor switches (22, 24; 22a, 24a), and whereby for the detection of an earth fault of the brake coil (26) the relays (28, 30) are opened and a current is measured with a first measuring circuit (40) from the first contact (32) of the positive relay (28) to the second contact (38) of the negative relay (30) and/or with a second measuring circuit (48) from the first contact (36) of the negative relay (30) to the second contact (34) of the positive relay (28), which current signal is fed to a control or safety circuit (62) of the passenger conveyor.

15. Method according to claim 14, wherein the current signal of the measuring circuit (40, 48) is fed to the control or safety circuit (62) of the passenger conveyor via an opto-coupler (58, 60).
